# EUROPEAN PATENT SPECIFICATION

(11) **EP 0 547 048 B1**
(45) Date of publication and mention of the grant of the patent: **26.07.1995**
(21) Application number: 90912353.1
(22) Date of filing: 24.08.1990
(51) Int. Cl.: C23C 14/24, C30B 23/06, H05B 3/64, C30B 25/10, H05B 3/40

(54) **HEATER FOR AN EFFUSION CELL**
HEIZUNG FÜR EFFUSIONSZELLE
DISPOSITIF DE RECHAUFFEMENT DE CELLULE D'EFFUSION

(43) Date of publication of application: 23.06.1993
(73) Proprietor: DCA INSTRUMENTS OY, SF-20520 Turku (FI)
(72) Inventor: LEVOLA, Tapani, SF-21100 Naantali (FI); VANHATALO, Jari, SF-20380 Turku (FI); SALMINEN, Lasse, SF-21250 Masku (FI); KANERVAMÄKI, Mikko, SF-20610 Turku (FI)
(74) Representative: Gallafent, Richard John (GB)
(86) International application number: FI9000201
(87) International publication number: WO9203588

(56) References cited:
- EP-A- 0 122 088
- EP-A- 0 249 516
- EP-A- 0 251 891
- DE-A- 1 921 938
- DE-A- 1 925 033
- DE-A- 2 608 510
- DE-A- 3 601 010
- DE-C- 876 875
- GB-A- 1 076 297
- PATENT ABSTRACTS OF JAPAN, vol. 10, no. 63, C332, abstract of JP 60200895, publ 1985-10-11 (KOGYO GIJUTSUIN).

## Description

This invention relates to effusion cells used in Molecular Beam and Chemical Beam Epitaxy systems including a crucible for source material and a heater for heating the crucible.

Molecular Beam Epitaxy (MBE) is a thin film growth process in which one or more thermal beams of atoms or molecules, emanating from solid or liquid source materials, react on the surface of a substrate to form a film. The substrate is held at an elevated temperature under ultra high vacuum (UHV) conditions. The substrate determines the crystallinity and orientation of the grown layer. The deposition rate is typically one micrometer per hour with thickness control of tenths of a monolayer and with purity levels of better than ten parts per million. Predetermined doping and compositional profiles can be fabricated in a layer-by-layer manner, with device-quality minority and majority carrier characteristics.

Chemical Beam Epitaxy (CBE) also belongs to the epitaxial technology. In CBE the solid sources employed in conventional MBE are replaced by gaseous sources. Thus CBE combines features of MBE and metalorganic chemical vapor deposition (MOCVD). Being an ultra high vacuum (UHV) technique, CBE possesses the molecular beam nature and the use of all-vapor source simultaneously. Therefore it provides extraordinary versatility in the growth of layered semiconductor systems while permitting the use of phosphorus. CBE has been proven to grow very high quality GaInAsP/InP, one of the most important semiconductor heterostructures practically unattainable by MBE.

The Molecular Beam methods have matured to the point that they are being seriously considered for industrial production of device structures. Semiconductor device fabrication plants will need high throughput systems capable of growing large-area wafers in batches.

Molecular Beam Epitaxy and Chemical Beam Epitaxy systems require ultra high vacuum conditions and equipment of very high quality. However the question of extreme purity is always a problem in all vacuum chamber systems when emanating from solid, liquid or gaseous sources.

To provide a molecular beam of very high purity in the Molecular Beam Epitaxy, the Knudsen-type effusion cell is used in the vacuum chamber. For evaporation of solid materials a high temperature is needed and exact temperature stability control is necessary. However especially in effusion cells the high temperatures might cause troubles because in the temperature range up to 1600°C impurities from the cell construction might mix with the molecular beams.

In the Knudsen-type effusion cells the heating of the source material is obtained by different kinds of heating elements. Well-known is an effusion cell where the resistor filament line goes from one end of the cell to another end and back again mainly in the direction of the tubular cell. This kind of resistor is very sensitive to the deformation in high temperatures because of the thermal strain.

Another well-known heater resistor in the effusion cell is a double coil made of wire. The double coil arrangement is the only possibility to prevent the magnetic field effect achieved by this kind of coil. It is because two coils can be made to effect to the opposite directions and so to compensate the dipole fields of the two coils.

However the thin wire coil gives unbalanced heat transmission distribution from the resistor to the crucible. Therefore the temperature difference between the resistor and the outer level of the crucible is remarkably high. The consequence of that situation is that high temperature resistor coil easily causes impurities in to the molecular beam.

European Patent Applications 122088 and 249516 both describe an apparatus for molecular epitaxy which include heating elements. In EPA 122088, the heating elements consist of elongate metal strips which although corrugated to be self-supporting, are essentially flat. EPA 249516 discloses heating elements which consist of flat tantalum strips.

European Patent Application 251891 discloses a heating element which consists of two bifilarly-wound helices of graphite foil. However, this heating element is not disclosed for use in an effusion cell.

The purpose of this invention is to provide a new effusion cell for Molecular and Chemical Beam Epitaxy. According to the invention the heater for the crucible includes two bifilarly-wound helices of thin foil ribbon with each ribbon being of arched transverse cross-section along its length to give it stiffness.

The benefit of this kind of heater is that the foil ribbon is mechanically stiff and stable. The heat transmission distribution from the resistor to the crucible is good because the thin foil can cover nearly the whole surface area of the effusion cell. Consequently the temperature difference between the resistor and the crucible is insignificant causing almost no impurities in the molecular beam.

A preferred embodiment of the invention is described in the drawings, where
Figure 1 presents a sectional view of the effusion cell.
Figure 2 presents the section II-II of the figure 1.
Figure 3 presents the heating filaments of the effusion cell.
Figure 4 presents an enlarged section of the filament mounting in the effusion cell.
Figure 5 presents a cross section V-V of the effusion cell.

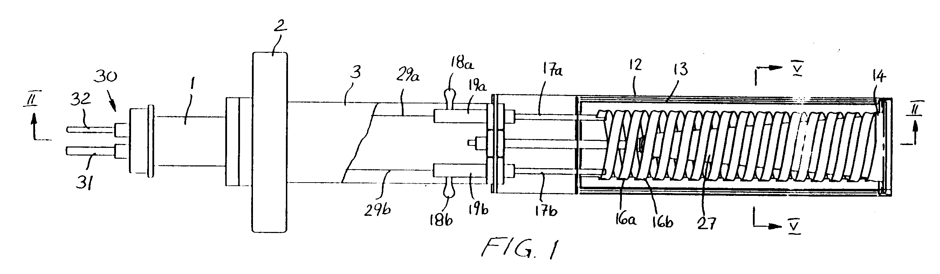

The effusion cell in figure 1 is mainly comprised of the supporting structure, means for holding solid sources for emanating and means for heating the solid source. The supporting structure comprises the feedthrough 1, the flange 2, the base rod 3, outer core 12 and inner core 13. Inside the tube formed cores 12 and 13 there is the crucible 27 for holding solid sources to be emanated surrounded by the heating filaments 16a and 16b.

The heating filaments 16a and 16b are resistors which are made of foil ribbons and connected to the electric power source by the current leads 17a and 17b. Electric current is brought through the flange 2 by cords 29a and 29b which have been attached to the connectors 19a and 19b by screws 18a and 18b.

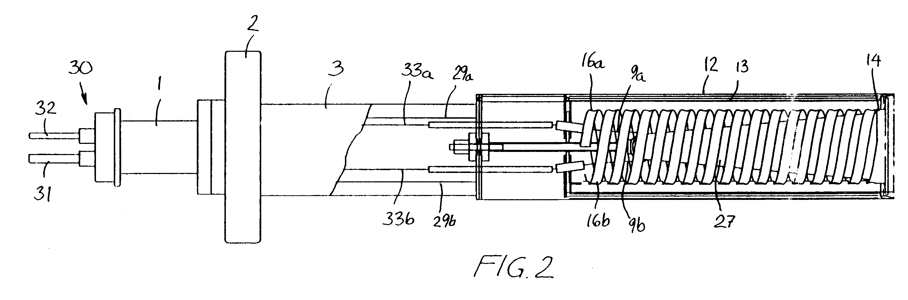

The effusion cell has a four point connecting plug 30 with two tags 31 for the heating filaments and two tags 32 for the thermoelement. In another sectional view of the effusion cell in the figure 2 the thermoelements 9a and 9b are seen. Thermoelements 9a and 9b measure the temperature of the crucible 27 and they are connected to the tags 32 by cords 33a and 33b.

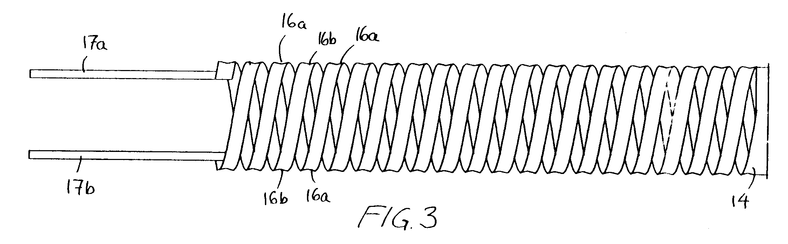

The figure 3 presents the heating filaments 16a and 16b of the effusion cell. The filaments 16a and 16b are made of foil ribbons of tantalum metal and form two spiral coils which have been bifilarly wound together. In the figure 3 it can be seen that every second round of the coils belongs to the filament 16a and every other round of the coils belongs to the filament 16b. Bifilarly wound filaments create no disturbing magnetic field when electric current is lead to the coils because two opposite coils compensate their dipole fields.

At the end of the heater, both filaments 16a and 16b have been joined to the hot ring 14 also made of foil material. The thickness of the hot ring 14 has been chosen so that the total connecting cross-sectional area in the ring is less than the cross-sectional area of the foil ribbon. Because the ring also acts as a resistor the consequence is that the ring 14 will be slightly hotter than the filament 16a or 16b itself. By this way the orifice of the crucible 27 will be at a higher temperature compared to the rest of the crucible. Consequently this arrangement improves the beam quality.

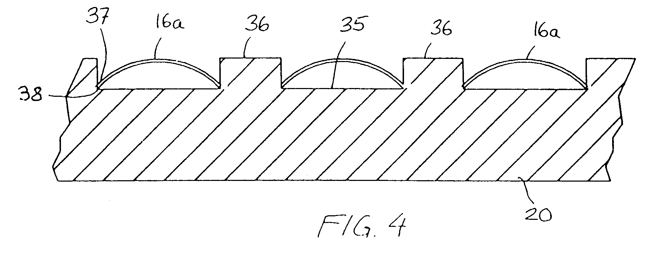

In the figure 4 an enlarged section of the filament coil mounting in the effusion cell is presented. Both filaments 16a and 16b have been mounted on the grooves 35 between the steps 36 in the filament holder 20. The figure 4 also shows very clearly the cross sectional form of the filament coil 16a. The filament coil 16a is basically a flat stripe that has been wound to the coil so that the cross section is concave or arched. This form makes the filament coil 16a very stable against deformation in high temperatures.

Another advantage of the concave form of the filament 16a arises from that the filament 16a is supported only by its edges. Because the contact areas between the filament and the holder 20 are very small the heat transfer from the filament to the holder will also be minimized. To make sure that the filament 16a stays in its place the filament has been fitted to the groove 35. During the operation the filament grabs efficiently to the corners 38 because of the thermal expansion.

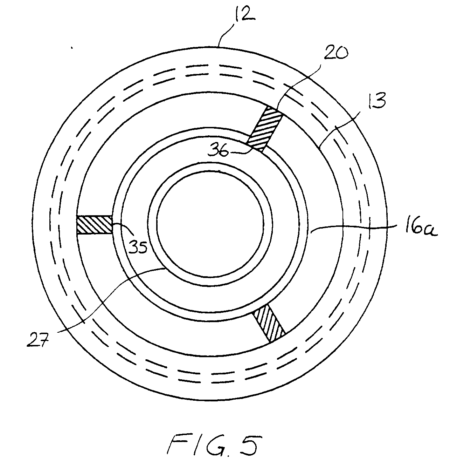

Figure 5 presents a cross section of the effusion cell. The filament coil 16a is mounted inside the outer core 12 and inner core 13 of the cell. The filament 16a is placed to the grooves 35 between the steps 36 in the filament holder 20. Inside the filament coil 16a the crucible 27 is seen in the figure 5.

## Claims

1. An effusion cell used in molecular beam and chemical beam epitaxy systems including a crucible (27) for source material and a heater (16, 20) for heating the crucible, characterised in that the heater (16, 20) for the crucible (27) includes two bifilarly wound helices (16a, 16b) of thin foil ribbon with each ribbon being of arched transverse cross section along its length to give it stiffness.

2. Effusion cell according to claim 1, characterised in that the foil ribbon (16a, 16b) in the effusion cell is placed into the grooves (35) of a holder (20) so that the foil ribbon is supported by its edges (37).

3. Effusion cell according to claim 2, characterised in that the edges (37) of the foil ribbon (16a, 16b) are supported by the corners (38) of the grooves (35) in the holder (20).

4. Effusion cell according to any one of the claims 1 to 3, characterised in that at the end of the effusion cell the foil ribbons (16a, 16b) are interconnected by a foil ring (14) with the total connecting cross-sectional area less than the cross-sectional area of the foil ribbon.

## Patentansprüche

1. Effusionszelle zur Verwendung in Epitaxiesystemen mit Molekularstrahlen und chemischen Strahlen, enthaltend einen Tiegel (27) für ein Ausgangsmaterial und eine Heizvorrichtung (16, 20) zur Erwärmung des Tiegels, dadurch gekennzeichnet, daß die Heizvorrichtung (16, 20) für den Tiegel (27) zwei doppelgängig gewickelte Wendein (16a, 16b) aus dünnem Folienband umfaßt, wobei jede Wendel entlang ihrer Länge einen gebogenen tranversalen Querschnitt aufweist, um ihr Steifigkeit zu geben.

2. Effusionszelle nach Anspruch 1, dadurch gekennzeichnet, daß das Folienband (16a, 16b) in der Effusionszelle in die Vertiefungen (35) eines Halters (20) gelegt ist, so daß das Folienband durch seine Ränder (37) gehalten ist.

3. Effusionszelle nach Anspruch 2, dadurch gekennzeichnet, daß die Ränder (37) des Folienbandes (16a, 16b) durch die Ecken (38) der Vertiefungen (35) in dem Halter (20) gehalten sind.

4. Effusionszelle nach einem der Ansprüche 1 bis 3, dadurch gekennzeichnet, daß an dem Ende der Effusionszelle die Folienbänder (16a, 16b) durch einen Folienring (14) miteinander verbunden sind, wobei die gesamte verbindende Querschnittsfläche kleiner als die Querschnittsfläche des Folienbandes ist.

## Revendications

1. Cellule d'effusion utilisée dans des systèmes d'épitaxie par faisceau moléculaire et par faisceau chimique comprenant un creuset (27) pour une matière source et un élément de chauffage (16, 20) pour chauffer le creuset, caractérisé en ce que l'élément de chauffage (16, 20) pour le creuset (27) comprend deux hélices enroulées de façon bifilaire (16a, 16b) de rubans de feuille mince, chaque ruban étant de coupe transversale arquée tout le long de sa longueur pour lui donner sa rigidité.

2. Cellule d'effusion selon la revendication 1, caractérisée en ce que le ruban de feuille (16a, 16b) dans la cellule d'effusion est placé à l'intérieur des sillons (35) d'un support (20) de sorte que le ruban de feuille est supporté par ces bords (37).

3. Cellule d'effusion selon la revendication 2, caractérisée en ce que les bords (37) du ruban de feuille (16a, 16b) sont supportés par les angles (38) des sillons (35) dans le support (20).

4. Cellule d'effusion selon l'une quelconque des revendications 1 à 3, caractérisé en ce qu'à l'extrémité de la cellule d'effusion les rubans de feuille (16a, 16b) sont reliées par un anneau de feuille (14), la surface totale en coupe transversale de la liaison étant inférieure à la surface en coupe transversale du ruban de feuille.
